# EUROPÄISCHE PATENTSCHRIFT

(11) **EP 2 537 067 B1**
(45) Veröffentlichungstag und Bekanntmachung des Hinweises auf die Patenterteilung: **20.08.2014**
(21) Anmeldenummer: 11707361.9
(22) Anmeldetag: 14.02.2011
(51) Int. Cl.: G03F 7/00

(54) **VERFAHREN UND VORRICHTUNG ZUM AKTIVEN KEILFEHLERAUSGLEICH ZWISCHEN ZWEI IM WESENTLICHEN ZUEINANDER PARALLEL POSITIONIERBAREN GEGENSTÄNDEN**
METHOD AND DEVICE FOR ACTIVE WEDGE ERROR COMPENSATION BETWEEN TWO OBJECTS THAT CAN BE POSITIONED SUBSTANTIALLY PARALLEL TO EACH OTHER
PROCÉDÉ ET DISPOSITIF POUR COMPENSER ACTIVEMENT UNE ERREUR DE COIN ENTRE DES OBJETS POUVANT ÊTRE DISPOSÉS DE MANIÈRE SENSIBLEMENT PARALLÈLE

(30) Priorität: 15.02.2010 DE 102010007970
(43) Veröffentlichungstag der Anmeldung: 26.12.2012
(73) Patentinhaber: SUSS MicroTec Lithography GmbH, 85748 Garching (DE)
(72) Erfinder: HANSEN, Sven, 85748 Garching (DE); CONRADI, Matthias, 85748 Garching (DE); FINK, Georg, 85748 Garching (DE)
(74) Vertreter: Vossius & Partner
(86) Internationale Anmeldenummer: PCT/EP2011/052141
(87) Internationale Veröffentlichungsnummer: WO 2011/098604

(56) Entgegenhaltungen:
- EP-A1- 2 299 472
- WO-A2-01/33300
- DE-C2- 2 607 607
- KR-A- 20050 081 921
- US-A1- 2005 275 251
- US-A1- 2009 251 699
- US-B1- 6 214 692

## Beschreibung

Die Erfindung betrifft ein Verfahren und eine Vorrichtung zum Keilfehlerausgleich, und insbesondere ein Verfahren und eine Vorrichtung, bei denen der zur Verfügung stehende Stellweg für den Keilfehlerausgleich vergrößert werden kann.

Bei der Herstellung von mikroelektronischen, mikrooptischen und mikromechanischen Bauelementen werden Strukturen mit Hilfe einer Maske bzw. einem Stempel durch Präge- oder Inprintlithographie auf ein Substrat übertragen. Kommt es zu einer Änderung des Winkels zwischen der Ebene der Maske und der Ebene des Substrats, dann werden die Strukturen nicht mehr gleichmäßig in das Substrat geprägt. In diesem Fall spricht man von einem Keilfehler. Der Keilfehlerausgleich bestimmt daher wesentlich die Qualität der Prägung.

Prinzipiell gibt es zwei Arten des Keilfehlerausgleichs, nämlich den passiven Keilfehlerausgleich und den aktiven Keilfehlerausgleich.

Beim passiven Keilfehlerausgleich fährt der Keilfehlerausgleichskopf mit oder ohne Substrat gegen die Maske bzw. den Stempel. Der Kontakt zur Maske erfolgt hierbei entweder vollflächig oder über Abstandsfahnen. Nachdem sich der bewegliche Teil des Keilfehlerausgleichskopfs bzw. das Substrat an die Maske angelegt hat, wird die relative Stellung von Maske und dem beweglichen Teil des Keilfehlerausgleichskopfs durch das Anlegen von Bremsen arretiert. Der Winkel, der zwischen der Ebene der Maske und der Ebene des Substrats bzw. der Oberfläche des beweglichen Teils des Keilfehlerausgleichskopfs gebildet wird, bleibt für mindestens einen Prozesszyklus erhalten.

Beim passiven Keilfehlerausgleich besteht ein Problem darin, dass die Bremsen nur eine relativ geringe Kraft von etwa 100 N halten können. Für SÜSS MicroTec Mikrolinsen Imprint Lithography (SMILE™), Substrate Conformal Imprint Lithography (SCIL) und Nanoimprint Lithography (NIL) Prozesse ist diese Kraft zu gering.

Um die Nachteile des passiven Keilfehlerausgleichs zu beheben, wird der aktive Keilfehlerausgleich verwendet. Der aktive Keilfehlerausgleich erfolgt zunächst wie der passive Keilfehlerausgleich. Anstelle der Arretierung der relativen Stellung der Maske zum beweglichen Teil des Keilfehlerausgleichskopfs bzw. zum Substrat werden Messtaster verwendet, die diese relative Stellung referenzieren. Anschließend wird der bewegliche Teil des Keilfehlerausgleichskopfs auf drei in der Referenzebene, z.B. im azimutalen Abstand von 120° angeordneten, linearen Stellgliedern aufgelegt. Mit Hilfe der Messtaster und durch Betätigung der linearen Stellglieder kann der Keilfehler aktiv ausgeglichen werden. Werden für die linearen Stellglieder Piezoelemente verwendet, so können typischerweise Stellwege bis 80 µm ausgeglichen werden. Dabei ist als Stellweg die maximal zur Verfügung stehende Strecke zu verstehen, um den ein lineares Stellglied den beweglichen Teil relativ zum stationären Teil des Keilfehlerausgleichskopfs verschieben kann.

Ein Problem bei diesem aktiven Keilfehlerausgleich ist der geringe Stellweg, insbesondere dann, wenn für die linearen Stellglieder beispielsweise Piezoelemente eingesetzt werden. Bei einem kompakten System ist der zur Verfügung stehende Bauraum begrenzt. Daher können die Piezoelemente nicht verlängert werden, um den Stellweg zu vergrößern. Die für den eigentlichen Prägehub zur Verfügung stehenden Stellwege reduzieren sich weiter, wenn bereits zum Toleranzausgleich der Abmessungen der im System verwendeten Bauelemente, z.B. des Chucks, des Adapterrahmens, des Maskenhalters, des Substrathalters usw., die maximal zur Verfügung stehenden Stellwege weitgehend benötigt werden. Das kann soweit gehen, dass für den eigentlichen Prägehub nur noch wenige Mikrometer übrigbleiben.

Im Hinblick auf die vorstehend erwähnten Probleme des Stands der Technik ist es Aufgabe der vorliegenden Erfindung, ein Verfahren und eine Vorrichtung bereitzustellen, bei denen der für den Keilfehlerausgleich zur Verfügung stehende Stellwege vergrößert wird. Es ist eine weitere Aufgabe der Erfindung, den Stellweg der linearen Stellglieder nahezu voll für den Prägehub nutzen zu können. Diese Aufgaben werden durch die Merkmale der Patentansprüche gelöst.

Dabei geht die Erfindung von dem Grundgedanken aus, die Toleranzen der im System verwendeten Bauelemente und des Substrats vorab grob z.B. durch Keile auszugleichen, so dass nur ein geringer Teil, z.B. 10 %, des Stellwegs der linearen Stellglieder für den verbleibenden Keilfehlerfeinausgleich erforderlich ist. Der verbleibende Stellweg der linearen Stellglieder kann daher nahezu vollständig für den Prägehub zum Bearbeiten des Substrats genutzt werden.

Der Keilfehlerausgleichskopf zum Ausgleichen des Keilfehlers weist einen stationären Teil, einen beweglichen Teil und lineare Stellglieder auf. Der bewegliche Teil ist über die linearen Stellglieder mit dem stationären Teil verbunden. Ein Ende eines jeden linearen Stellglieds ist direkt mit einem der beiden Teile des Keilfehlerausgleichskopfs verbunden oder liegt an einem Widerlager des betreffenden Teils des Keilfehlerausgleichskopfs an. Zwischen dem anderen Ende eines jeden linearen Stellglieds und dem anderen Teil des Keilfehlerausgleichskopfs erfolgt ein Grobausgleich z.B. durch Einschieben von Keilen. Bevorzugt werden drei lineare Stellglieder verwendet, die in der Referenzebene z.B. im azimutalen Abstand von 120° symmetrisch angeordnet sind. Damit lässt sich der bewegliche Teil des Keilfehlerausgleichskopfs relativ zum stationären Teil des Keilfehlerausgleichskopfs beliebig positionieren.

Mit Hilfe der Keile können Toleranzen der sich im System befindenden Bauteile einschließlich des Substrats grob ausgeglichen werden. Beispielsweise kann der bewegliche Teil des Keilfehlerausgleichskopfs bei einem nicht gleichmäßig dicken Substrat, bei dem die Dicke von einem Rand zum anderen Rand abfällt, über die Keile so ausgerichtet werden, dass das Substrat nahezu parallel zu einer Maske zum Prägen von Strukturen in das Substrat ist. Mit Hilfe der linearen Stellglieder kann dann eine feine Korrektur der Parallelität von Substrat und Maske erfolgen und schließlich der Prägehub zur Strukturierung des Substrats durch gleichmäßige Betätigung aller linearen Stellglieder ausgeführt werden.

Um eine kompakte Bauweise der Vorrichtung zu ermöglichen, können die Keile im beweglichen Teil oder im stationären Teil des Keilfehlerausgleichskopfs integriert werden Der bewegliche Teil des Keilfehlerausgleiehskopfs kann zur Aufnahme des Substrats dienen. In diesem Fall wird der bewegliche Teil des Keilfehlerausgleichskopfs mit dem Substrat gegen eine feststehende Maske gedrückt, um Strukturen in das Substrat zu prägen. Alternativ kann die Maske auf dem beweglichen Teil des Keilfehlerausgleichskopfs angeordnet werden, so dass bei Betätigung der linearen Stellglieder die Maske zum Prägen gegen das feststehende Substrat gedrückt wird.

Die linearen Stellglieder weisen bevorzugt Piezoelemente auf. Die Auslenkung der linearen Stellglieder bzw. die Auslenkung der Keile erfolgt individuell für jedes lineare Stellglied bzw. für jeden Keil mit Hilfe einer Steuereinrichtung: Die Auslenkung, d.h. die Verschiebung der Keile erfolgt bevorzugt pneumatisch.

In einer Ausführungsform sind die linearen Stellglieder hochpräzis und haben insbesondere nur kleine Arbeitsbereiche (Stellwege auch im nm-Bereich).

Mit Hilfe von Messtastern an einer feststehenden Halterung zur Aufnahme der Maske oder des Substrats, die die Oberfläche des beweglichen Teils kontaktieren, kann die Stellung des beweglichen Teils des Keilfehlerausgleichskopfs relativ zu dieser Halterung gemessen werden. Alternativ können andere Sensoren verwendet werden. Diese Sensoren messen die Position von Sensorstiften, die am beweglichen Teil des Keilfehlerausgleichkopfs befestigt sind. Bevorzugt werden mindestens drei dieser Messtaster oder Sensoren verwendet.

Mit Hilfe von Bremsen kann die Stellung des beweglichen Teils des Keilfehlerausgleichskopfs relativ zum stationären Teil des Keilfehlerausgleichskopfs arretiert werden.

Alternativ werden die Keile nicht aktiv ausgerichtet, um den Keilfehler auszugleichen. In diesem Fall werden die Keile lediglich nach dem Ausrichten und Arretieren des beweglichen Teils des Keilfehlerausgleichskopfs zwischen die linearen Stellglieder und einen Teil des Keilfehlerausgleichskopfs geschoben, um die Lücken zu füllen. Auch auf diese Weise wird ein grober Ausgleich des Keilfehlers erzielt. Nach dem Lösen der Bremsen ist nur ein geringer Stellweg der linearen Stellglieder nötig, um den Keilfehlerfeinausgleich durchzuführen.

Der erfindungsgemäße Keilfehlerausgleich kann folgendermaßen beschrieben werden: Zuerst erfolgt ein grober Ausgleich des Keilfehlers, der durch Toleranzen der im System verwendeten Bauelemente einschließlich des Substrats hervorgerufen wird, mit Hilfe der Positionierung der Keile. Danach erfolgt ein Feinausgleich eines eventuell noch vorhandenen geringen Keilfehlers mit Hilfe der linearen Stellglieder. Dadurch steht bei dem nun folgenden Prägehub nahezu der maximale Stellweg der linearen Stellglieder noch zur Verfügung.

Im Detail kann der erfindungsgemäße Keilfehlerausgleich auf folgende Weise ausgeführt werden: Zunächst wird der Keilfehlerausgleichskopf bzw. dessen beweglicher Teil gegen eine in einer feststehenden Halterung angeordnete Maske bewegt, damit die Stellung des beweglichen Teils des Keilfehlerausgleichskopfs in dieser Position bestimmt werden kann. Durch das Anlegen von Bremsen wird der Winkel zwischen der Maske und der Oberfläche des Keilfehlerausgleichskopfs bzw. des sich auf dem Keilfehlerausgleichskopf befindenden Substrats arretiert. Im Anschluss daran wird der Keilfehlerausgleichskopf bzw. der bewegliche Teil des Keilfehlerausgleichskopfs von der Maske wegbewegt. Danach werden die Keile zwischen die linearen Stellglieder und den beweglichen Teil des Keilfehlerausgleichskopfs geschoben. Anschließend werden die Bremsen geöffnet. Durch die Überprüfung der Stellung des beweglichen Teils des Keilfehlerausgleichskopfs mit Hilfe der Messtaster bzw. der Sensoren können die Keile entsprechend nachjustiert werden. Diese Nachjustage der Keile kann jedoch auch entfallen. Damit ist die grobe Positionierung der Stellung des beweglichen Teils des Keilfehlerausgleichskopfs abgeschlossen. Im Anschluss erfolgt die Feinausrichtung der Stellung des beweglichen Teils des Keilfehlerausgleichskopfs mit Hilfe der linearen Stellglieder. Da der Stellweg der linearen Stellglieder nicht zum groben Ausgleich des Keilfehlers und eventueller Toleranzen benötigt wurde, steht nach dem Feinausgleich des Keilfehlers nahezu der gesamte Stellweg der linearen Stellglieder noch für den-Prägehub zur Verfügung.

Die Erfindung wird nachstehend mit Bezug auf die Zeichnungen näher erläutert. Es zeigen:
Fig. 1 eine Schnittansicht durch eine Vorrichtung zum Keilfehlerausgleich vor der Messung der Stellung des beweglichen Teils des Keilfehlerausgleichskopfs (Referenzmessung),
Fig. 2 eine Schnittansicht durch die Vorrichtung zum Keilfehlerausgleich bei der Referenzmessung, und
Fig. 3 eine Schnittansicht durch die Vorrichtung zum Keilfehlerausgleich nach dem Messen und Ausgleichen des Keilfehlers und vor dem Prägehub.

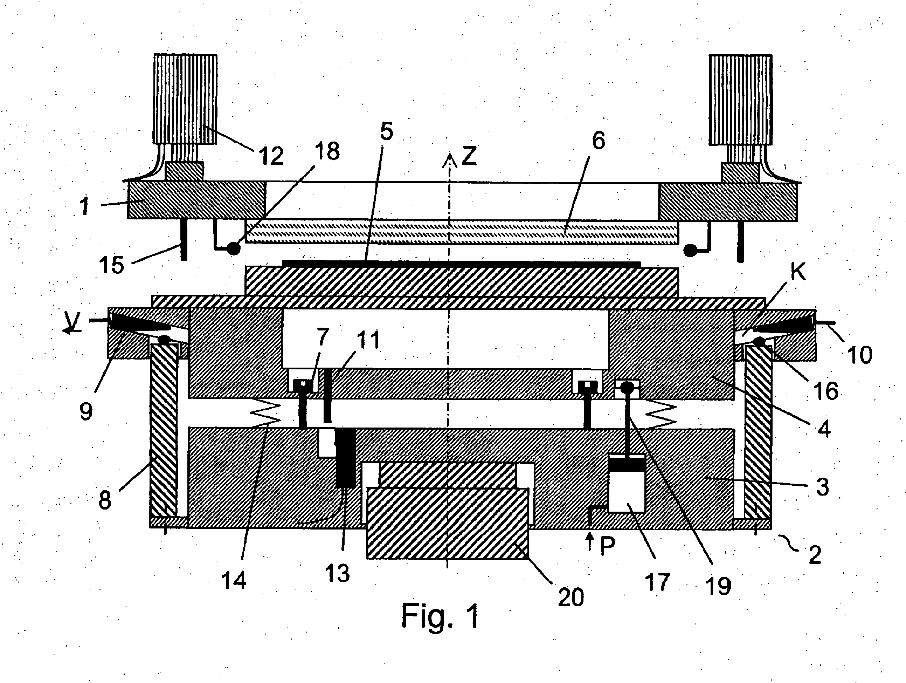

Fig. 1 zeigt eine Schnittansicht durch eine Vorrichtung zum aktiven Keilfehlerausgleich. Mit der Vorrichtung können Strukturen in ein Substrat 5 geprägt werden. Die Vorrichtung besteht aus dem erfindungsgemäßen Keilfehlerausgleichskopf 2 und einer Halterung 1, an der eine Maske (oder Stempel) 6, die Strukturen in das Substrat 5 prägt, befestigt ist.

Der Keilfehlerausgleichskopf 2 weist einen beweglichen Teil 4 und einen stationären Teil 3 auf. Zwischen dem beweglichen Teil 4 und dem stationären Teil 3 sind Druckfedern 14 vorgesehen. Mit einer hydraulisch oder pneumatisch arbeitenden Einrichtung 17 können der bewegliche Teil 4 und der nichtbewegliche Teil 3 aufeinander zu bewegt werden, indem ein Kolben 19, der am beweglichen Teil 4 befestigt ist, durch Unterdruck in der Einrichtung 17, die sich im stationären Teil 3 befindet, auf den stationären Teil 3 zu bewegt wird. Mit Hilfe der Bremsen 7 lässt sich der bewegliche Teil 4 relativ zum stationären Teil 3 arretieren. Auf der freien Oberfläche des Keilfehlerausgleichskopfs 2 wird das zu bearbeitende Substrat 5 aufgebracht.

Der bewegliche Teil 4 des Keilfehlerausgleichskopfs 2 ist ferner über lineare Stellglieder 8 mit dem stationären Teil 3 des Keilfehlerausgleichskopfs 2 verbunden. Dabei sind die linearen Stellglieder an einem Ende direkt mit dem stationären Teil des Keilfehlerausgleichskopfs 2 verbunden. Am anderen Ende der linearen Stellglieder 8 befindet sich ein Auflageelement 16. Keile 9 können in dafür vorgesehenen Kanälen K verschoben werden, so dass ein Kontakt zwischen Auflageelement 16 und Keil 9 einerseits und Keil 9 und beweglichem Teil 4 andererseits erreicht werden kann. In Fig. 1 sind zwei lineare Stellglieder 8 dargestellt. Bevorzugt verfügt der Keilfehlerausgleichskopf 2 drei lineare Stellglieder 8, die im azimutalen Abstand von 120° symmetrisch angeordnet sind (in Prägerichtung Z betrachtet). Weiter weisen die linearen Stellglieder 8 bevorzugt Piezoelemente auf. Durch gleichzeitiges Auslenken aller Stellglieder 8 erfolgt der Prägehub, der den beweglichen Teil 4 des Keilfehlerausgleichskopfs 2 mit dem Substrat 5 auf die Maske 6 drückt.

An der Halterung 1 sind neben der Maske 6 auch Abstandsfahnen 18 befestigt. Die Abstandsfahnen 18 könnten zwischen Maske 6 und Substrat 5 eingeschoben werden.

Die Vorrichtung gemäß Fig. 1 weist zudem Messtaster 15 auf. Die Messtaster 15 sind durch Bohrungen in der Halterung 1 mit Messköpfen 12 verbunden. Die Messköpfe 12 detektieren die Bewegung bzw. Stellung der Messtaster 15 und liefern ein entsprechendes Signal an eine nicht dargestellte Steuereinrichtung. Mit ihren freien Enden oder Spitzen können die Messtaster die Oberfläche des beweglichen Teils 4 des Keilfehlerausgleichskopfs kontaktieren, um die Stellung des beweglichen Teils 4 zu ermitteln. Bevorzugt werden mindestens drei in Azimutrichtung bezüglich der Prägeachse Z um jeweils 120° versetzte Messtaster 15 mit zugehörigen Messköpfen 12 eingesetzt, um die Stellung des beweglichen Teils 4 in der Ebene genau messen zu können.

Im stationären Teil 3 des Keilfehlerausgleichskopfs 2 ist ein Sensor 13 vorgesehen, der die Bewegung bzw. Stellung eines am beweglichen Teil 4 des Keilfehlerausgleichskopfs 2 befestigten Sensorstifts 11 ermittelt. Bevorzugt werden mindestens drei in Azimutrichtung bezüglich der Prägeachse Z um jeweils 120° versetzte Paare eines Sensors 13 und eines Sensorstifts 11 eingesetzt. Die Sensoren 13 und Sensorstifte 11 bieten eine weitere Möglichkeit, um die Stellung des beweglichen Teils 4 des Keilfehlerausgleichskopfs 2 zu messen.

Der gesamte Keilfehlerausgleichskopf 2 kann über eine Hubeinrichtung 20 in Prägerichtung Z bewegt werden. Es ist beispielsweise nötig, den Keilfehlerausgleichskopf 2 mit der Hubeinrichtung 20 weit von der Halterung 1 wegzubewegen, um das Substrat 5 und/oder die Maske 6 zu wechseln.

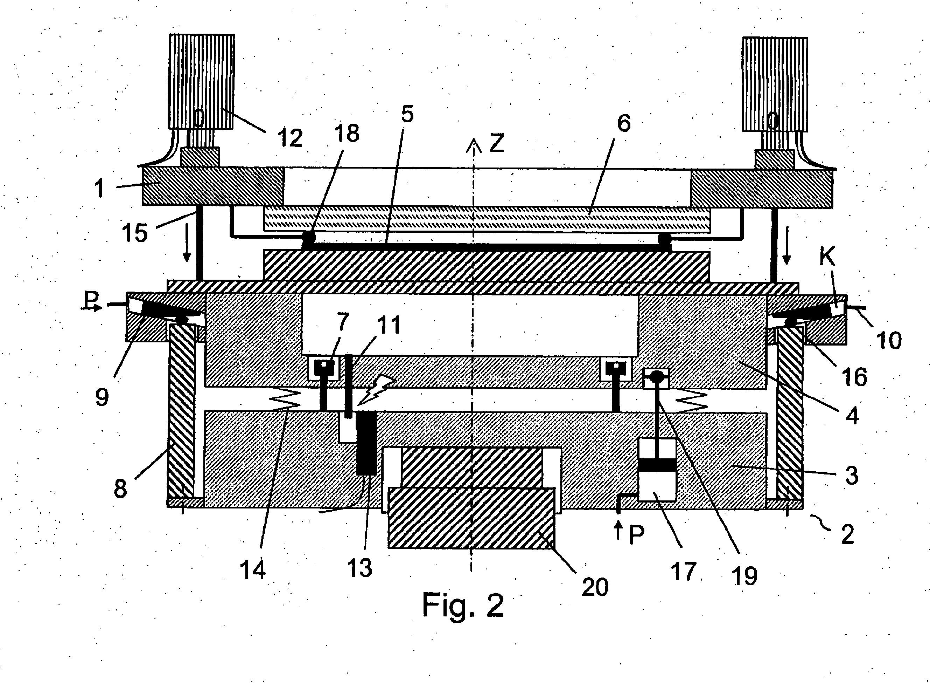

Fig. 2 zeigt eine Schnittansicht durch die Vorrichtung zum Keilfehlerausgleich bei der Messung der Stellung des beweglichen Teils 4 des Keilfehlerausgleichskopfs 2. Um später einen Keilfehler ausgleichen zu können, muss zunächst eine Referenzmessung durchgeführt werden. Es muss ermittelt werden in welcher Stellung des beweglichen Teils 4 des Keilfehlerausgleichskopfs 2 der Winkel zwischen Substrat 5 und Maske 6 minimal ist, d.h. wann die beiden Elemente optimal parallel ausgerichtet sind. Dazu können Abstandsfahnen 18 zwischen Substrat 5 und Maske 6 eingefügt werden. Danach wird der bewegliche Teil 4 soweit in Richtung Maske 6 gefahren, bis die Abstandsfahnen 18 sowohl das Substrat 5 als auch die Maske 6 kontaktieren.

Mit Hilfe der Messtaster 15 oder der Sensoren 13 wird die Referenzmessung durchgeführt. Alternativ kann die Referenzmessung auch ohne Abstandsfahnen 18 durchgeführt werden, indem die Maske 6 und das Substrat 5 direkt in Kontakt gebracht werden.

Gemäß Fig. 2 werden nach der Referenzmessung die Keile 9 soweit in den dafür vorgesehenen Kanälen K verschoben, dass die Keile 9 sowohl den beweglichen Teil 4 als auch die Auflageelemente 16 kontaktieren. Das Verschieben der Keile 9 erfolgt pneumatisch mit Hilfe der Druckluftanschlüsse 10.

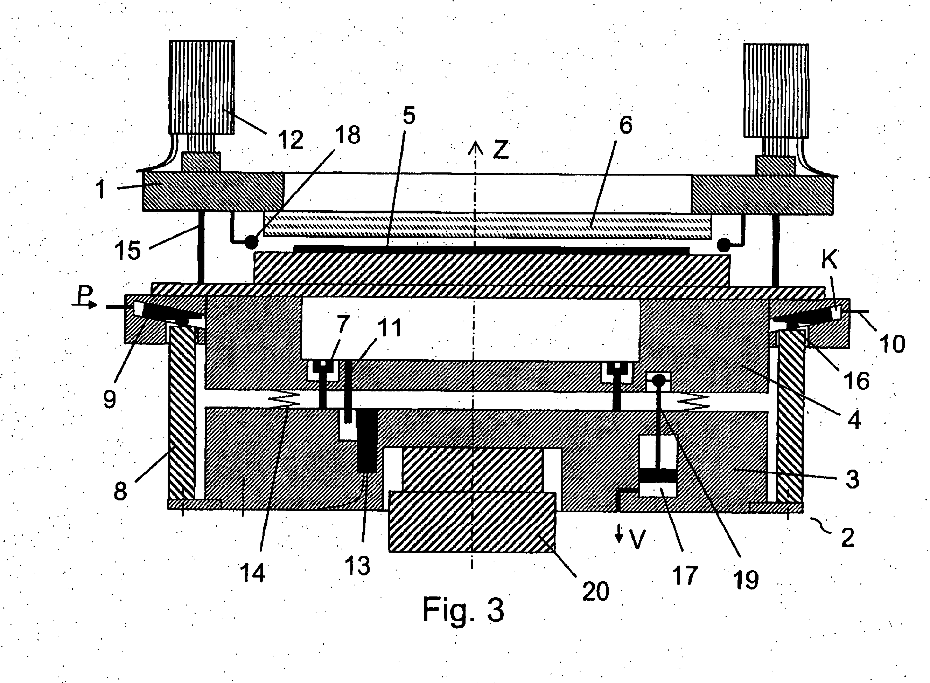

Fig. 3 zeigt die erfindungsgemäße Vorrichtung nachdem die Abstandsfahnen 18 wieder entfernt wurden. Der Keilfehler und die Toleranzen der im System verwendeten Bauteile einschließlich des Substrats 5 wurden bereits grob durch die Keile 9 ausgeglichen. Mit den linearen Stellgliedern 8 erfolgt der Feinausgleich des Keilfehlers. Da der Grobausgleich bereits erfolgt ist, werden nur geringe Stellwege der linearen Stellglieder 8 für den Feinausgleich benötigt. Beispielsweise werden nur etwa 10 % des maximalen zur Verfügung stehenden Stellwegs eines linearen Stellglieds 8 für den Feinausgleich benötigt. Damit verbleiben etwa 90 % des maximalen Stellwegs der linearen Stellglieder 8 für den anschließenden Prägehub.

Im Folgenden wird eine mögliche Abfolge von Schritten eines erfindungsgemäßen Keilfehlerausgleichs beschrieben:
In Schritt 1 wird zunächst geprüft, ob die Keile in ihrer Grundstellung sind. Sind sie nicht in der Grundstellung, dann werden sie in die Grundstellung gebracht. Als Grundstellung wird die Position bezeichnet, wenn sich die Keile 9, wie in Fig. 1 gezeigt, in einer äußeren Position weit entfernt von den linearen Stellgliedern 8 befinden.
In Schritt 2 wird der Keilfehlerausgleichskopf 2 gegen eine Maske 6 bewegt, damit das Substrat 5 bzw. der bewegliche Teil 4 parallel zur Maske 6 ausgerichtet wird.
In Schritt 3 wird die Stellung des beweglichen Teils 4 des Keilfehlerausgleichskopfs 2 gemessen. Diese Referenzmessung ist nötig, damit der bewegliche Teil 4 des Keilfehlerausgleichskopfs 2 vor dem Prägen wieder in dieser exakten Stellung ausgerichtet werden kann.
In Schritt 4 wird der Winkel zwischen dem Substrat 5 bzw. dem beweglichen Teil 4 des Keilfehlerausgleichskopfs 2 und der Maske 6 durch das Anlegen von Bremsen arretiert.
In Schritt 5 entfernt sich der Keilfehlerausgleichskopf 2 von der Maske 6.
In Schritt 6 werden die Keile 9 durch Verschieben zwischen die linearen Stellglieder 8 und den beweglichen Teil 4 des Keilfehlerausgleichskopfs 2 geklemmt.
In Schritt 7 wird der bewegliche Teil 4 des Keilfehlerausgleichskopfs 2 durch den Kolben 19 der Einrichtung 17 auf die linearen Stellglieder 8 gezogen.
In Schritt 8 werden die Bremsen 7 geöffnet. Damit wird die Stellung des beweglichen Teils 4 des Keilfehlerausgleichskopfs 2 durch die Position der Keile 9 bestimmt.
In Schritt 9 kann die Position der Keile 9 überprüft und verbessert werden.
In Schritt 10 erfolgt der Feinausgleich des Keilfehlers aktiv mit Hilfe der linearen Stellglieder 8. Dabei wird die in Schritt 3 gemessene Stellung des beweglichen Teils 4 des Keilfehlerausgleichskopfs 2 als Referenzstellung verwendet.

Danach ist die Vorrichtung zum Prägehub in Z-Richtung durch synchrone Ansteuerung der linearen Stellglieder 8 bereit.

vorstehend wurde die Erfindung mit der Maske 6 an der feststehenden Halterung 1 und dem Substrat 5 auf dem beweglichen Teil 4 erläutert. Alternativ zur Darstellung in Fig. 1 bis 3 kann im Rahmen der Erfindung umgekehrt die Maske 6 am beweglichen Teil 4 des Keilfehlerausgleichskopfs 2 angeordnet sein, wobei dann dementsprechend das Substrat 5 an der Halterung 1 befestigt wird.

Zudem wurde vorstehend beschrieben, dass die Keile 9 aktiv verstellbar sind, um den Keilfehlergrobausgleich möglichst genau durchzuführen. Alternativ werden die verstellbaren Keile lediglich nach dem Messen der Referenzstellung und dem Arretieren des beweglichen Teils 4 des Keilfehlerausgleichskopfs 2 einmalig zwischen die linearen Stellglieder 8 und einen Teil des Keilfehlerausgleichskopfs geschoben. Dabei können die Keile die linearen Stellglieder 8 und den entsprechenden Teil des Keilfehlerausgleichskopfs bereits berühren, allerdings ohne dass es zu einer Veränderung der Stellung der beteiligten Elemente kommt. Alternativ wird der Keil gerade so weit verschoben, dass es nicht zu einer Berührung von Keil und linearem Stellglied 8 bzw. dem entsprechenden Teil des Keilfehlerausgleichskopfs kommt. Diese Verschiebung des Keils kann z.B. mit Hilfe eines geeigneten Sensors überwacht werden. Nachdem der Keil positioniert ist, werden die Bremsen gelöst. Aufgrund der Positionierung der Keile wurde der Keilfehler bereits grob ausgeglichen. Für den Keilfehlerfeinausgleich wird nur noch ein geringer Stellweg der linearen Stellglieder benötigt.

Alternativ können statt der Druckfedern 14 Zugfedern verwendet werden. Zwischen dem beweglichen Teil 4 und dem stationären Teil 3 befinden sich dann Zugfedern. In diesem Fall können der bewegliche Teil 4 und der nichtbewegliche Teil 3 mit einer hydraulisch oder pneumatisch arbeitenden Einrichtung 17 auseinander bewegt werden, indem ein Kolben 19, der am beweglichen Teil 4 befestigt ist, durch Überdruck in der Einrichtung 17, die sich im stationären Teil 3 befindet, vom stationären Teil 3 wegbewegt wird.

## Patentansprüche

1. Keilfehlerausgleichskopf (2)
zum Durchführen des aktiven Keilfehlerausgleichs, mit:
einem stationären Teil (3) und einem demgegenüber beweglichen Teil (4); und
mindestens drei linearen Stellgliedern (8), zwischen den beiden Teilen (3 und 4),
wobei zwischen den linearen Stellgliedern (8) und dem beweglichen Teil (4) oder dem stationären Teil (3) verstellbare Keile (9) vorgesehen sind.

2. Keilfehlerausgleichskopf (2) nach Anspruch 1, wobei die Keile (9) im beweglichen Teil (4) oder im stationären Teil (3) des Keilfehlerausgleichskopfs (2) integriert sind.

3. Keilfehlerausgleichskopf (2) nach Anspruch 1 oder 2, wobei der bewegliche Teil (4) mit einer Maske (6) oder mit einem Substrat (5) verbindbar ist.

4. Keilfehlerausgleichskopf (2) nach einem der Ansprüche 1 bis 3, wobei jedes lineare Stellglied (8) ein Piezoelement aufweist.

5. Keilfehlerausgleichskopf (2) nach einem der Ansprüche 1 bis 4, mit einer pneumatischen oder hydraulischen Einrichtung zum individuellen Verstellen der Keile (9).

6. Keilfehlerausgleichskopf (2) nach einem der Ansprüche 1 bis 5, mit einer Steuereinrichtung zum individuellen Steuern bzw. Regeln der Verstellung jedes einzelnen Keils (9).

7. Keilfehlerausgleichskopf (2) nach einem der Ansprüche 1 bis 6, mit mindestens drei Messtastern (15) bzw. mindestens drei Sensoren (13) zum Messen der Stellung des beweglichen Teils (4) des Keilfehlerausgleichskopfs (2).

8. Keilfehlerausgleichskopf (2) nach einem der Ansprüche 1 bis 7, mit mehreren Bremsen (7) zum Arretieren der Stellung des beweglichen Teils (4) des Keilfehlerausgleichskopfs (2).

9. Vorrichtung zum Prägen eines Substrats (5) mit einem Keilfehlerausgleichskopf (2) nach einem der Ansprüche 1 bis 8.

10. Verfahren zum aktiven Keilfehlerausgleich mit einem Keilfehlerausgleichskopf (2) nach einem der Ansprüche 1 bis 8, mit den Schritten:
a) Durchführen einer Grobjustierung des Keilfehlerausgleichs mit Hilfe der Keile (9); und
b) Durchführen einer Feinjustierung des Keilfehlerausgleichs mit Hilfe der linearen Stellglieder (8).

11. Verfahren nach Anspruch 10, mit den Schritten a1) bis a8) innerhalb des Schritts a) und des Schritts b1) innerhalb des Schritts b):
a1) Bewegen des Keilfehlerausgleichskopfs (2) gegen eine Maske (6) bzw. ein Substrat (5);
a2) Messen der Stellung des beweglichen Teils (4) des Keilfehlerausgleichskopfs (2) mit Messtastern (15) bzw. Sensoren (13);
a3) Arretieren des Winkels zwischen dem Keilfehlerausgleichskopf (2) eventuell mit Substrat (5) bzw. Maske (6) und der Maske (6) bzw. dem Substrat (5), durch das Anlegen von Bremsen (7);
a4) Entfernen des Keilfehlerausgleichskopfs (2) von der Maske (6) bzw. dem Substrat (5);
a5) Positionieren der Keile (9) zwischen den linearen Stellgliedern (8) und dem beweglichen Teil (4) des Keilfehlerausgleichskopfs (2);
a6) Verbinden des beweglichen Teils (4) des Keilfehlerausgleichskopfs (2) mit den Keilen (9) und Kontaktieren der linearen Stellglieder (8) mit den Keilen (9);
a7) Öffnen der Bremsen (7);
a8) Überprüfen der Stellung des beweglichen Teils (4) des Keilfehlerausgleichskopfs (2) mit Hilfe der Messtaster (15) bzw. der Sensoren (13) und entsprechendes Ausrichten der Keile (9); und
b1) aktives Ausgleichen des Keilfehlers mit Hilfe der linearen Stellglieder (8) und der in Schritt a2) gemessenen Stellung des beweglichen Teils (4) des Keilfehlerausgleichskopfs (2).

## Claims

1. A wedge error compensating head (2) for carrying out an active wedge error compensation, comprising:
a stationary part (3) and a part (4) being movable relative thereto; and
at least three linear actuators (8) between the two parts (3 and 4),
wherein displaceable wedges (9) are provided between the linear actuators (8) and the movable part (4) or the stationary part (3).

2. The wedge error compensating head (2) according to claim 1, wherein the wedges (9) are integrated in the movable part (4) or in the stationary part (3) of the wedge error compensating head (2).

3. The wedge error compensating head (2) according to claim 1 or 2, wherein the movable part (4) can be connected with a mask (6) or a substrate (5).

4. The wedge error compensating head (2) according to any one of claims 1 to 3, wherein each linear actuator (8) comprises a piezo element.

5. The wedge error compensating head (2) according to any one of claims 1 to 4, comprising a pneumatic or hydraulic means for individually moving the wedges (9).

6. The wedge error compensating head (2) according to any one of claims 1 to 5, comprising a controller for individually controlling or regulating the movement of the individual wedges (9).

7. The wedge error compensating head (2) according to any one of claims 1 to 6, comprising at least three measuring probes (15) or at least three sensors (13) for measuring the position of the movable part (4) of the wedge error compensating head (2).

8. The wedge error compensating head (2) according to any one of claims 1 to 7, comprising a plurality of brakes (7) for locking the position of the movable part (4) of the wedge error compensating head (2).

9. A device for imprinting or embossing a substrate (5) by means of a wedge error compensating head (2) according to any one of claims 1 to 8.

10. A method for actively compensating for a wedge error by using a wedge error compensating head (2) according to any one of claims 1 to 8, comprising the steps of:
(a) carrying out a coarse adjustment of the wedge error compensation by means of the wedges (9); and
(b) carrying out a fine adjustment of the wedge error compensation by means of the linear actuators (8).

11. The method according to claim 10, comprising steps (a1) to (a8) within step (a) and step (b1) within step (b):
(a1) moving the wedge error compensating head (2) against a mask (6) or a substrate (5);
(a2) measuring the position of the movable part (4) of the wedge error compensating head (2) by means of measuring probes (15) or sensors (13);
(a3) locking the angle between the wedge error compensating head (2), possibly with substrate (5) or mask (6), and the mask (6) or the substrate (5) by applying brakes (7);
(a4) removing the wedge error compensating head (2) from the mask (6) or the substrate (5);
(a5) positioning the wedges (9) between the linear actuators (8) and the movable part (4) of the wedge error compensating head (2);
(a6) connecting the movable part (4) of the wedge error compensating head (2) with the wedges (9) and contacting the linear actuators (8) with the wedges (9);
(a7) opening the brakes (7);
(a8) checking the position of the movable part (4) of the wedge error compensating head (2) by means of the measuring probes (15) or the sensors (13) and accordingly aligning the wedges (9); and
(b1) actively compensating for the wedge error by means of the linear actuators (8) and the position of the movable part (4) of the wedge error compensating head (2) measured in step (a2).

## Revendications

1. Tête de compensation d'erreur de coin (2) pour exécuter la compensation active d'erreur de coin, avec :
une partie fixe (3) et une partie mobile (4) par rapport à celle-ci ; et
au moins trois organes de réglage linéaires (8) entre les deux parties (3 et 4),
des coins réglables (9) étant prévus entre les organes de réglage linéaires (8) et la partie mobile (4) ou la partie fixe (3).

2. Tête de compensation d'erreur de coin (2) selon la revendication 1, où les coins (9) sont intégrés dans la partie mobile (4) ou dans la partie fixe (3) de la tête de compensation d'erreur de coin (2).

3. Tête de compensation d'erreur de coin (2) selon la revendication 1 ou la revendication 2, où la partie mobile (4) peut être raccordée à un masque (6) ou à un substrat (5).

4. Tête de compensation d'erreur de coin (2) selon l'une des revendications 1 à 3, où chaque organe de réglage linéaire (8) comporte un élément piézo-électrique.

5. Tête de compensation d'erreur de coin (2) selon l'une des revendications 1 à 4, avec un dispositif pneumatique ou hydraulique pour le réglage individuel des coins (9).

6. Tête de compensation d'erreur de coin (2) selon l'une des revendications 1 à 5, avec un dispositif de commande pour la commande ou la régulation individuelles du déplacement de chaque coin (9).

7. Tête de compensation d'erreur de coin (2) selon l'une des revendications 1 à 6, avec au moins trois palpeurs de mesure (15) ou au moins trois capteurs (13) pour la mesure de position de la partie mobile (4) de la tête de compensation d'erreur de coin (2).

8. Tête de compensation d'erreur de coin (2) selon l'une des revendications 1 à 7, avec plusieurs freins (7) pour la fixation de position de la partie mobile (4) de la tête de compensation d'erreur de coin (2).

9. Dispositif d'estampage d'un substrat (5) avec une tête de compensation d'erreur de coin (2) selon l'une des revendications 1 à 8.

10. Procédé de compensation active d'erreur de coin avec une tête de compensation d'erreur de coin (2) selon l'une des revendications 1 à 8, comprenant les étapes suivantes :
a) exécution d'un réglage grossier de la compensation d'erreur de coin au moyen des coins (9) ; et
b) exécution d'un réglage de précision de la compensation d'erreur de coin au moyen des organes de réglage linéaires (8).

11. Procédé selon la revendication 10, comprenant les étapes a1) à a8) incluses dans l'étape a) et l'étape b1) incluse dans l'étape b) :
a1) déplacement de la tête de compensation d'erreur de coin (2) contre un masque (6) ou un substrat (5) ;
a2) mesure de position de la partie mobile (4) de la tête de compensation d'erreur de coin (2) par des palpeurs de mesure (15) ou des capteurs (13) ;
a3) fixation de l'angle entre la tête de compensation d'erreur de coin (2), éventuellement avec substrat (5) ou masque (6), et le masque (6) ou le substrat (5), par application de freins (7) ;
a4) retrait de la tête de compensation d'erreur de coin (2) du masque (6) ou du substrat (5) ;
a5) positionnement des coins (9) entre les organes de réglage linéaires (8) et la partie mobile (4) de la tête de compensation d'erreur de coin (2) ;
a6) raccordement de la partie mobile (4) de la tête de compensation d'erreur de coin (2) avec les coins (9) et mise en contact des organes de réglage linéaires (8) avec les coins (9) ;
a7) ouverture des freins (7) ;
a8) contrôle de position de la partie mobile (4) de la tête de compensation d'erreur de coin (2) au moyen des palpeurs de mesure (15) ou des capteurs (13) et alignement correspondant des coins (9) ; et
bl) compensation active de l'erreur de coin au moyen des organes de réglage linéaires (8) et de la position mesurée en étape a2) de la partie mobile (4) de la tête de compensation d'erreur de coin (2).
